Europäisches Patentamt

European Patent Office

Office européen des brevets

(11) Numéro de publication: **0 354 079**
A1

## (12) DEMANDE DE BREVET EUROPEEN

(21) Numéro de dépôt: 89401922.3

(22) Date de dépôt: 05.07.89

(51) Int. Cl.5: **H 01 F 40/06**
G 01 R 15/02

(30) Priorité: 05.08.88 FR 8810619

(43) Date de publication de la demande:
07.02.90 Bulletin 90/06

(84) Etats contractants désignés:
AT BE CH DE ES FR GB IT LI LU NL SE

(71) Demandeur: ABB PETERCEM S.A.
10, Rue Ampère
F-69680 Chassieu (FR)

(72) Inventeur: Abraham, Claude
177, Rue Duguesclin
F-69003 Lyon (FR)

Marciot, Denis
27, Quai Jayr
F-69009 Lyon (FR)

(74) Mandataire: Laget, Jean-Loup et al
Cabinet Pierre Loyer 77, rue Boissière
F-75116 Paris (FR)

(54) Transformateur d'intensité pour courants continus, alternatifs ou pulsés.

(57) Transformateur d'intensité pour courants continus, alternatifs ou pulsés.
Au voisinage de l'entrefer, le circuit magnétique 2 présente au moins un portion à section réduite.

*Fig.3*

EP 0 354 079 A1

## Description

### Transformateur d'intensité pour courants continus, alternatifs ou pulsés

L'invention concerne un transformateur d'intensité pour courants continus, alternatifs ou pulsés.

Un transformateur d'intensité de ce type comprend essentiellement un conducteur primaire entouré d'un circuit magnétique à entrefer, une sonde magnéto-sensible placée dans l'entrefer et fournissant un signal électrique à un amplificateur qui alimente un enroulement secondaire bobiné sur le circuit magnétique. Le signal électrique de la sonde est fonction du champ magnétique induit dans le circuit magnétique par le courant passant dans le conducteur primaire. Il est amplifié par l'amplificateur et appliqué à l'enroulement pour annuler le champ magnétique induit par le courant primaire. Par la mesure du courant secondaire on obtient ainsi une mesure du courant primaire.

Ce type de transformateur d'intensité fonctionne de façon satisfaisante pour les variations relativement faibles du courant primaire. Cependant, la linéarité de la réponse est affectée par les fortes variations du courant primaire. En particulier, les pointes de courant de grande amplitude sont mal appréciées.

Un but de la présente invention est de proposer une structure du circuit magnétique au voisinage de l'entrefer qui permette de mieux mesurer les pointes de courant, et plus généralement les fortes variations d'intensité du courant primaire.

L'invention a pour objet un transformateur d'intensité pour courants continus, alternatifs ou pulsés, comprenant un conducteur primaire entouré d'un circuit magnétique à entrefer, et une sonde magnéto-sensible placée dans l'entrefer et fournissant un signal électrique à un amplificateur qui alimente un enroulement secondaire bobiné sur le circuit magnétique de façon à annuler le champ magnétique induit par le courant primaire, caractérisé en ce que, au voisinage de l'entrefer, le circuit magnétique présente au moins une portion à section réduite, de telle sorte que, en cas de forte amplitude ou de forte variation du courant primaire, cette portion se sature et le circuit magnétique présente un entrefer apparent de largeur sensiblement égale à la distance séparant les deux extrémités de la partie à section non réduite du circuit magnétique.

Selon une caractéristique de l'invention, la portion à section réduite du circuit magnétique est disposée d'un seul côté de l'entrefer.

A titre d'exemple, on a représenté aux dessins annexés :

Figure 1 - une schéma simplifié d'un transformateur d'intensité pour courants continus, alternatifs ou pulsés de type connu;

Figure 2 - une vue de face de l'entrefer du circuit magnétique de la figure 1;

Figure 3 - une vue de face d'un mode de réalisation de l'entrefer du circuit magnétique d'un transformateur d'intensité, selon l'invention.

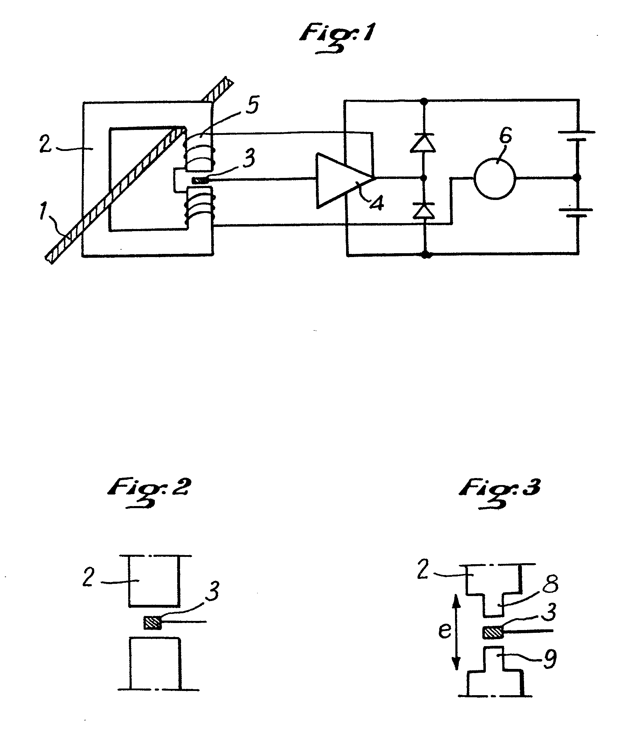

Sur la figure 1 on voit que le transformateur d'intensité pour courants continus, alternatifs ou pulsés, de type connu comprend essentiellement un conducteur primaire 1, entouré par un circuit magnétique 2, dans l'entrefer duquel est placée une sonde 3 magnéto-sensible, par exemple à effet Hall. Cette sonde délivre un signal électrique fonction du champ magnétique induit par le courant primaire du conducteur 1. Ce signal, amplifié par l'amplificateur 4 est appliqué à l'enroulement 5 bobiné sur le circuit magnétique 2 de façon à annuler le champ magnétique qui engendre le signal électrique. Un appareil 6 est prévu afin d'obtenir, par la mesure du courant secondaire, une mesure du courant primaire

La figure 2 montre la forme usuelle du circuit magnétique au droit de l'entrefer : la section du circuit magnétique est constante de part et d'autre de l'entrefer, qui est obtenu par exemple par fraisage de toute la section du circuit magnétique.

La figure 3 montre un exemple de réalisation du circuit magnétique selon l'invention. Au voisinage de l'entrefer, en regard de la sonde 3, la section du circuit magnétique 2 est réduite pour constituer des pôles rétrécis, en forme de barres transversales ou de doigts 8, 9. Cette réduction de section peut être brusque, ou progressive pour constituer des pôles tronconiques. Elle peut être prévue d'un seul côté de l'entrefer.

La réduction de section du circuit magnétique concentre le champ magnétique au droit de la sonde 3. Lorsque l'amplitude du courant primaire est faible, et/ou lorsque les variations du courant sont faibles, la concentration du champ magnétique permet d'augmenter la sensibilité de la sonde 3.

Au contraire, lorsque l'amplitude du courant primaire est forte, et/ou lorsque ses variations sont fortes, les pôles rétrécis 8, 9 se saturent et le circuit magnétique 2 présente un entrefer apparent de largeur e sensiblement égale à la distance séparant les deux extrémités de la partie à section non réduite du circuit magnétique.

Cette disposition permet au transformateur d'intensité selon l'invention de mesurer des courants primaires de très forte amplitude, et de très fortes variations du courant primaire. Elle permet également d'améliorer la linéarité de la réponse sur l'ensemble du domaine de mesure.

Dans la description qui précède, le circuit magnétique a été représenté avec un seul entrefer. L'invention couvre également le cas d'un circuit magnétique à plusieurs entrefers, dont au moins l'un présente une portion à section réduite.

## Revendications

1. - Transformateur d'intensité pour courants continus, alternatifs ou pulsés, comprenant un conducteur primaire entouré d'un circuit magnétique à entrefer, et une sonde magnéto-sensible placée dans l'entrefer et fournissant un signal électrique à un amplificateur qui alimente un enroulement secondaire bobiné sur le circuit magnétique de façon à annuler le champ magnétique induit par le courant primaire, caractérisé en ce que, au voisinage de l'entrefer, le circuit magnétique (2) présente au moins une portion à section réduite , de telle sorte que, en cas de forte amplitude ou de forte variation du courant primaire, cette portion se sature et le circuit magnétique (2) présente un entrefer apparent de largeur sensiblement égale à la distance séparant les deux extrémités de la partie à section non réduite de circuit magnétique.

2. - Transformateur d'intensité selon la revendication 1, caractérisé en ce que la portion à section réduite du circuit magnétique est disposée d'un seul côté de l'entrefer.

*Fig. 1*

*Fig. 2*

*Fig. 3*

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0242560 (PORTH)<br>* colonne 1, lignes 27 - 48 *<br>* colonne 2, lignes 20 - 40; figure 1 *<br>--- | 1. | H01F40/06<br>G01R15/02 |
| A | EP-A-0194225 (LEM)<br>----- | | |

**DOMAINES TECHNIQUES RECHERCHES (Int. Cl.5)**

H01F
G01R

Le présent rapport a été établi pour toutes les revendications

| Lieu de la recherche | Date d'achèvement de la recherche | Examinateur |
|---|---|---|
| LA HAYE | 19 OCTOBRE 1989 | BIJN E.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)